# EUROPEAN PATENT SPECIFICATION

(11) **EP 1 672 971 B1**
(45) Date of publication and mention of the grant of the patent: **01.11.2017**
(21) Application number: 04773225.0
(22) Date of filing: 10.09.2004
(51) Int. Cl.: H05K 3/12, H05K 3/24, H05K 3/46, H01L 21/48

(54) **METHOD FOR MANUFACTURING A SUBSTRATE**
VERFAHREN ZUR HERSTELLUNG EINES SUBSTRATS
Procédé de fabrication d'un substrat

(30) Priority: 12.09.2003 JP 2003321751
(43) Date of publication of application: 21.06.2006
(73) Proprietor: National Institute of Advanced Industrial Science and Technology, Tokyo 100-8921 (JP); HARIMA CHEMICALS, INC., Kakogawa-shi, Hyogo-ken 657-0019 (JP); SIJTechnology, Inc., Tsukuba Ibaraki 305-8565 (JP)
(72) Inventor: MURATA, Kazuhiro; c/o N.I.A.I.S.T., Tsukuba-shi (JP); YOKOYAMA, Hiroshi; c/o N.I.A.I.S.T., Tsukuba-shi (JP); ITOH, Daisuke; c/o Tsukuba Research Laboratory, Tsukuba-shi, Ibaraki 3002635 (JP); IZUMITANI, A.; c/o Tsukuba Research Laboratory, Tsukuba-shi, Ibaraki 3002635 (JP); HATA, Noriaki; c/o Tsukuba Research Laboratory, Tsukuba-shi, Ibaraki 3002635 (JP); MATSUBA, Y.; c/o Tsukuba Research Laboratory, Tsukuba-shi, Ibaraki 3002635 (JP)
(74) Representative: Forstmeyer, Dietmar
(86) International application number: PCT/JP2004/013581
(87) International publication number: WO 2005/027600

(56) References cited:
- WO-A1-03/070381
- CH-A5- 673 920
- JP-A- 10 315 479
- JP-A- 2001 088 306
- JP-A- 2002 299 833
- JP-A- 2002 324 966
- JP-A- 2003 133 692
- JP-A- 2003 142 802
- JP-A- 2003 209 341
- JP-A- 2003 218 149
- US-A- 5 746 868
- US-A1- 2003 061 710
- US-B1- 6 501 663
- SAWYER B FULLER ET AL: "Ink-Jet Printed Nanoparticle Microelectromechanical Systems", JOURNAL OF MICROELECTROMECHANICAL SYSTEMS, IEEE SERVICE CENTER, US, vol. 11, no. 1, 1 February 2002 (2002-02-01), XP011034684, ISSN: 1057-7157
- KAZUHIRO MURATA ED - ANONYMOUS: "Direct Fabrication of Super -Fine Wiring and Bumping by Using Inkjet process", POLYMERS AND ADHESIVES IN MICROELECTRONICS AND PHOTONICS, 2007. POLYTR ONIC 2007. 6TH INTERNATIONAL CONFERENCE ON, IEEE, PI, 1 January 2007 (2007-01-01), pages 293-296, XP031139386, ISBN: 978-1-4244-1130-6
- MURATA K: "Super-fine ink-jet printing for nanotechnology", MEMS, NANO AND SMART SYSTEMS, 2003. PROCEEDINGS. INTERNATIONAL CONFERE NCE ON JULY 20-23, 2003, PISCATAWAY, NJ, USA,IEEE, 20 July 2003 (2003-07-20), pages 346-349, XP010650489, ISBN: 978-0-7695-1947-0

## Description

### Technical Field

The present invention relates to substrates for semiconductor chips or the like, and a method of preparing the same; specifically, substrates wherein a metal pillar produced by use of a fine inkjet method is used, and a method of preparing the substrates.

### Backgound Art

As a method of depositing a metal to form metal pillars or bumps, various methods are known (for example, JP-A-11-163207 ("JP-A" means unexamined published Japanese patent application.)). However, with all of the methods, it is impossible easily to produce metal pillars extending long in the vertical direction, and fine metal pillars or bumps each having a small bottom face.

For example, with a plating method which has been widely diffused, it is impossible to form a thick film. According to this method, it is also difficult to deposit a fine metal layer only on prescribed positions. According to screen printing method, a transferring method, and a general inkjet method, out of methods of using metal particulates, it is impossible to form required metal pillars or fine bumps. A method of using piezoelectric inkjets to form a three-dimensional structure on a substrate is disclosed (see JP-A-2003-218149 and JP-A-2004-228375). However, the diameter of the bottom face of the structure is, at the smallest, 30 µm or more. Thus, the method is unsatisfactory in making substances in a fine size. Liquid droplets discharged by this method are as large as several picoliters to ten-odd picoliters, and the droplets flow out after landed if the liquid droplets are left as they are. Therefore, whenever liquid droplets are discharged, it is necessary to conduct the step of solidifying the liquid droplets by hot wind treatment, firing treatment, or some other treatment. Thus, this method cannot be adopted from the viewpoint of efficiency for industrial applicability.

Multi-layered substrates become the main currents for substrates used in fields associated with electronic equipment in recent years. Further, to attain electronic conduction between substrates in these multi-layered substrates, there is generally adopted a method of making through holes in the substrates, filling electroconductive paste into the holes, and then sintering the substrates. However, as to this method, operations therefor are complicated. Further, in the case that the diameters of the through holes are not somewhat large, the electroconductive paste cannot be filled thereinto. This causes an obstruction to miniaturization of substrates, which is a recent theme. As to working to make the holes also, the lower limit of the diameter of holes that can be made by mechanical working is about 10 µm, and it is very difficult to make holes having a diameter of 10 µm or less.

Other and further features and advantages of the invention will appear more fully from the following description, taken in connection with the accompanying drawings. EP1477230 (which is a family document in the English language of WO03070381, which is in time and therefore regarded as prior art) discloses the printing of cylindrical structures using polyvinylphenol and an ultrafine fluid jet apparatus by an active tapping action of the nozzle.

### Brief Description of Drawings

Figs. 1(a) to 1(f) are explanatory views illustrating a method of preparing substrates of the present invention. Fig. 1(a) illustrates formation of metal pillars; Fig. 1(b) illustrates embedding of the metal pillars; Fig. 1(c) illustrates formation of a perforated substrate; Fig. 1(d) illustrates formation of a chip-mounted substrate, and Figs. 1(e) and 1(f) illustrate formation of a multi-layered substrate.
Figs. 2(a) to 2(d) are explanatory views illustrating a method of preparing substrates of the present invention as to formation of a midair wiring substrate.
Fig. 3 is a field-emission-type scanning electron microscopic photograph (power: 750 magnifications) of metal pillars formed on a substrate in an example.
Fig. 4 is a field-emission-type scanning electron microscopic photograph (power: 4000 magnifications) of a metal sintered pad formed on a substrate in an example.

### Disclosure of Invention

According to the present invention, as defined in the claims there is provided the following means:
(1) A method of preparing substrates, comprising the steps of: depositing metal particulate into a pillar form on a prescribed position of a substrate by the use of a fine inkjet method; and then sintering the resultant to form a metal pillar.
(2) The method of preparing substrates according to item (1), wherein the metal pillar is a bump.
(3) The method of preparing substrates according to item (1), wherein a metal material is filled into a through hole made on the substrate so as to form a metal pillar.
(4) The method of preparing substrates according to item (1), wherein a height of the metal pillar is in a range of from 10 to 100 µm.
(5) The method of preparing substrates according to item (1) or (4), wherein a bottom face diameter of the metal pillar is in a range of from 0.5 to 10 µm.
(6) The method of preparing substrates according to item (2), wherein a bottom face diameter of the bump is in a range of from 0.5 to 50 µm.
(7) The method of preparing substrates according to item (3), wherein an inside diameter of the through hole is in a range of from 1 to 500 µm.
(8) The method of preparing substrates according to any one of items (1) to (7), wherein the fine inkjet method is a structure-forming method fine liquid droplet, drying and solidifying the liquid droplet, and stacking the solidified droplets by virtue of the focusing of an electric field.
(9) The method of preparing substrates according to any one of items (1) to (8), wherein the metal particulates are made of at least one metal selected from the group consisting of gold, silver, copper, platinum, palladium, tungsten, nickel, tantalum, bismuth, lead, indium, tin, zinc, titanium, and aluminum.
(10) The method of preparing substrates according to any one of items (1) to (9), wherein a particulate size of the metal particulates is in a range of from 1 to 100 nm.
(11) The method of preparing substrates according to any one of items (1) to (8), wherein the metal particulates are gold particulates having an average particulate size in a range of from 1 to 20 nm, and a dispersion containing the gold particulates in an amount of 40 % by mass or more is used as a fluid to be discharged.
(12) The method of preparing substrates according to any one of items (1) to (8), wherein the metal particulates are silver particulates having an average particulate size in a range of from 1 to 20 nm, and a dispersion containing the silver particulates in an amount of 40 % by mass or more is used as a fluid to be discharged.
(13) The method of preparing substrates according to any one of items (1) to (12), wherein a temperature for sintering the metal particulates is in a range of from 150 to 300°C.
(14) A method of producing chip-mounted substrates, comprising the steps of: forming a circuit on a substrate; forming a metal pillar at a prescribed position of the substrate in the method according to any one of items (1), (4), (5), and (8) to (13); mounting a member on the substrate; and sealing the resultant with a resin.
(15) A method of producing multi-layered substrates, comprising the steps of: forming a circuit on the chip-mounted substrate produced according to the method of item (14); and repeating the steps in the method of item (14).
(16) A method of producing chip-mounted substrates, comprising the steps of: forming a circuit on a substrate; forming a bump on a prescribed position of the substrate in the method according to any one of items (2), (6), and (8) to (13); and mounting a member on the bump.
(17) A method of producing multi-layered substrates, comprising the steps of: forming a circuit on a substrate; making a through hole in a prescribed position of the substrate; and embeding a metal into the through hole by the use of the method according to any one of items (3), (7) and (8) to (13).
(18) Substrates comprising a metal pillar formed by the use of a fine inkjet method, the metal pillar which is formed by that metal particulates are deposited in a pillar form at a prescribed position of a substrate, and the pillar formed metal particulates are sintered.
(19) The substrates according to item (18), wherein the metal pillar is a bump.
(20) The substrates according to item (18), wherein a height of the metal pillar is in a range of from 10 to 100 µm.
(21) The substrates according to item (18), wherein a bottom face diameter of the metal pillar is in a range of from 0.5 to 10 µm.
(22) The substrates according to item (18), wherein a bottom face diameter of the bump is in a range of from 0.5 to 50 µm.
(23) The substrates according to item (18), comprising the metal pillar formed at the prescribed position of the substrate, a member mounted on the pillar formed substrate, and the member mounted substrate is sealed with a resin.

### Best Mode for Carrying Out the Invention

Through eager investigations, the inventors found out and achieved that a metal particulate dispersion is discharged onto a substrate, and thereby the metal particulates is deposited on the substrate, by the use of an inkjet method capable of drawing fine images. The present invention is based on such findings.

The present invention will be further described hereinafter.

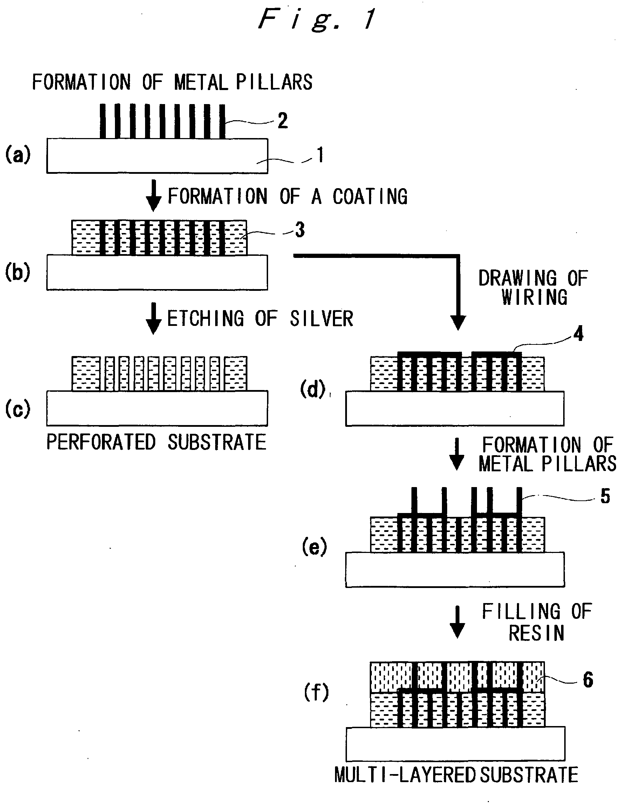

In the present invention, an electric field is used to cause fine fluid droplets to fly and land onto a substrate, and then quick-drying property and highspeed solidification of the fine fluid droplets are used to form fine three-dimensional structures (such as metal pillars and bumps) having a high aspect ratio (see Fig. 1(a)). In Figs. 1(a) to 1(f), reference numbers 1 and 2 represent a substrate and metal pillars, respectively. Specifically, ultra-fine inkjets are used to jet out fine liquid droplets. The three-dimensional structure in the present invention does not mean any mere two-dimensional circuit or pattern but means a structure the aspect ratio of which can freely be set and is, for example, 3 or more. The shape thereof may be a circular column or an elliptical column, and the projection shape thereof seen from the above may be linear. The three-dimensional structure may be an article having a remarkably larger thickness (height) than the line width thereof (by, for example, 3 times or more of the line width). Examples of the structure include a metal pillar and a bump.

An example of the fine inkjet device which can be used in the present invention is an electrohydrodynamic inkjet device or the like, e.g., described in JP-A-2004-165587, wherein a prescribed waveform voltage is applied to its nozzle tips to discharge fine droplets by electrostatic effect. The fine droplet in the present invention is a droplet the diameter of which is preferably 20 µm or less, more preferably 5 µm or less, particularly preferably 1 µm or less, but is not limited thereto.

The fine inkjet method used in the present invention makes it possible to discharge liquid droplets smaller than those obtained by conventional inkjet methods. When such an inkjet method capable of drawing fine images is used to jet out (or discharge) a metal particulate dispersion onto a substrate, the solvent in the applied metal particulate dispersion evaporates instantaneously from the dispersion by action of surface tension of the droplets, effect of its large specific surface area thereof, and other effects on the basis of the smallness of the liquid droplets. As a result, metal particulates adhere to the substrate. In other words, the present invention attains to form three-dimensional structure by flying and landing a ultra-fine liquid droplets and drying and solidifying the droplets, using the fine inkjet method. (In the present invention, the wording "drying and solidifying" means that the objects are vaporized and dried so as to make the viscosity of the objects themselves high in such a manner that the objects can be at least stacked.) Furthermore, conditions, such as collision energy, focusing of electric field, and a temperature of the substrate or its atmosphere, are appropriately controlled, whereby a structure having a height can be formed. Accordingly, according to the preparing method of the present invention, it is unnecessary to employ other steps of solidifying the droplets between intervals of discharging droplets. Thus, discharging and stacking of the fine liquid droplets are continuously attained so that a substrate having metal pillars can be effectively produced.

Further, in the ultra-fine inkjet by virtue of the effect of the applied electric field, stress directed to the tip of the nozzle constantly acts at a top part of a structure formed by the solidification of precedently adhering liquid droplets, which may be referred to as "precedently landed liquid droplets" hereinafter. Consequently, the structure can be grown while the structure is pulled towards the nozzles. It is therefore possible that even a structure having a high aspect ratio can be grown without being collapsed. When the growth of the structure is started, the electric field can be focused at its growing point. It is therefore possible to guide the discharged liquid droplets certainly and accurately to land onto the top of the structure made from the precedently adhering droplets. Thus, the growth of the structure can be effectively promoted. Conditions for growing the structure can be appropriately set in such a manner that the above-mentioned effects can be obtained, dependently on the nature of the liquid droplet fluid and others. For example, conditions described in Japanese patent application Nos. 2004-221937 and Japanese patent application Nos. 2004-221986 may be used.

The aspect ratio of the structure formed by the method of the present invention is not particularly limited, and is preferably 1 or more, more preferably 2 or more, even more preferably 3 or more, in particular preferably 5 or more. The aspect ratio does not have an upper limit. If the three-dimensional structure can stand up by itself, the structure can be unlimitedly grown in such a manner that the aspect ratio thereof will be 100 or more, or 200 or more.

Examples of the metal species in the paste of the metal particulates used in the present invention are almost all kinds of metals or oxides thereof. A preferable metal is a metal having electroconductivity such as gold, silver, copper, platinum, palladium, tungsten, tantalum, bismuth, lead, tin, indium, zinc, titanium, nickel, iron, cobalt, aluminum, or the like. A more preferable metal is gold, silver, copper, platinum, or palladium. A particularly preferable metal is gold or silver. A single metal may be used, or an alloy made of two or more metals may be used. A particle size of the metal particulates, which may be referred to as the "metal nano particles" hereinafter, is preferably from 1 to 100 nm, more preferably from 1 to 20 nm, even more preferably from 2 to 10 nm.

Since the liquid droplets of the jetted-out metal particulate dispersion, which may be referred to as the "metal particulate paste" hereinafter, are small, a bottom face diameter (or cross section diameter) of the metal pillar formed from the landed liquid droplets of the metal particulate dispersion, the metal pillar which may be referred to "metal particulate layer" hereinafter, can be made very small. The diameter of the metal particulate layer is preferably from 0.01 to 10 µm, more preferably from 0.5 to 10 µm, even more preferably from 0.5 to 5 µm. The metal particulate layers each having such a very small area are deposited and stacked in the vertical direction (the height direction) by continual jetting of the dispersion, so that columnar deposited layers made of the metal particulates can be produced. The height of the columnar deposited layers is preferably from 0.1 to 500 µm, more preferably from 1 to 100 µm, particularly preferably from 10 to 100 µm.

The solvent of the metal particulate paste used in the present invention can be classified into aqueous solvent and organic solvent on the basis of the dispersion manner thereof. The organic solvent can be further classified into solvent made mainly of a polar solvent and solvent made mainly of a nonpolar solvent. The solvent may be made of a mixture.

The solvent of the metal particulate paste used in the present invention may be water, tetradecane, toluene, alcohol or the like. The concentration of the metal fine particles in the dispersion or paste is desirably higher, and is preferably 40 % by mass or more, more preferably 45 % by mass or more. In this regard, the concentration can be decided, considering the fluidity, the vapor pressure, the boiling point and other properties of the solvent and conditions for forming a three-dimensional structure, for example, the temperature of the substrate and/or the atmosphere, the vapor pressure, and the amount of the discharged liquid droplets for the following reason: for example, in the case that the boiling point of the solvent is low, the solvent component evaporates when the liquid droplets fly or land; accordingly, in many cases, the particulate concentration at the time of the landing on a substrate is remarkably different from the discharged concentration of the particulates.

In order to form a three-dimensional structure, it is preferred that the viscosity of the metal particulate paste used in the present invention is high. It is, however, necessary that the viscosity is within such a range that the paste can be inkjetted. Thus, it is necessary to decide the viscosity with attention. The viscosity also depends on the kind of the paste. In the case of, for example, a silver nano paste, the viscosity is preferably from 3 to 50 centipoises (more preferably from 8 to 15 centipoises). In the case of a ceramics sol-gel liquid, a well-shaped columnar structure can be obtained though the viscosity of the solution which is considerably low. This would be because the boiling point of the solvent therein is low and thus the solvent evaporates at the time of the flying or landing of the liquid droplets so that the viscosity becomes higher abruptly.

After the formation of the columnar deposited layer, the layer is sintered by heating at a low temperature, whereby the particulates melt and adhere to each other so that a columnar metal layer can be formed. It is preferable that the sintering temperature is appropriately set in accordance with the natures of the used metal or alloy, such as the melting point thereof. The temperature is preferably from 100 to 500°C, more preferably from 150 to 300°C. The atmosphere at the time of the sintering may be air, an inert gas atmosphere, a reduced pressure atmosphere, a reducing gas atmosphere such as hydrogen, or the like. In order to prevent the metal ultra-fine particles from being oxidized, a reducing gas atmosphere is preferable.

Since the thus-formed metal pillar has a high metal content by percentage and has a finely firmed structure, the pillar exhibits a value close to the volume-electrical resistivity of the metal itself so that a low electrical resistance of 0.1 × 10⁻⁵ Ωcm or less can be attained.

The use of the metal particulates makes it possible that after the three-dimensional structure is formed, sintered and fixed, the structure (metal pillar) can be buried with, for example, a resin dissolved in an organic solvent (see Fig. 1(b)). In Figs. 1(a) to 1(f), reference number 3 represents the coating resin. In other words, in the case of a structure made of a resin material, dependently on a combination of the resin with an organic solvent the structure would be eroded by the solvent so that the structure itself may be broken; however, in the case that the metal particulates are used to form a structure, the structure can be made stable against the used organic solvent and so on by sintering the structure. Accordingly, a perforated substrate can be formed by etching and dissolving only the metal after the structure is buried with the resin or the like (see Fig. 1(c)). For the dissolution of the metal, for example, a ferric nitrate solution or a mixed solution of chromic anhydride and concentrated sulfuric acid can be used.

By mounting a chip on the substrate wherein the metal pillars are formed, and sealing the resultant with a resin so that a chip-mounted substrate wherein an electric conduction region is formed in the upper portion thereof can be produced (Fig. 1(d)).

In Figs. 1(a) to 1(f), reference number 4 represents circuit wiring. The sealing resin used at this time is preferably a thermosetting resin or ultraviolet curing resin, such as epoxy resin, phenol resin, or acrylic resin.

Furthermore, by forming a circuit on such a chip-mounted substrate, and sealing the resultant with a resin, whereby a multi-layered substrate wherein an electric conduction region is formed in the upper portion of the resin can be formed (see Figs. 1(e) and 1(f)). In Figs. 1(a) to 1(f), reference numbers 5 and 6 represent a metal pillar and a resin (coating resin), respectively. The formation of the circuits can be attained by any one of screen printing method, inkjet method, and transferring method using a metal particulate paste. The metal particulate paste used at this time is preferably the same metal species paste as used to deposit the metal pillars. However, a paste of a different metal species can be appropriately used. It is preferred to set the viscosity of the metal particulate paste and other physical properties thereof to ones suitable for circuit-formation or for deposition.

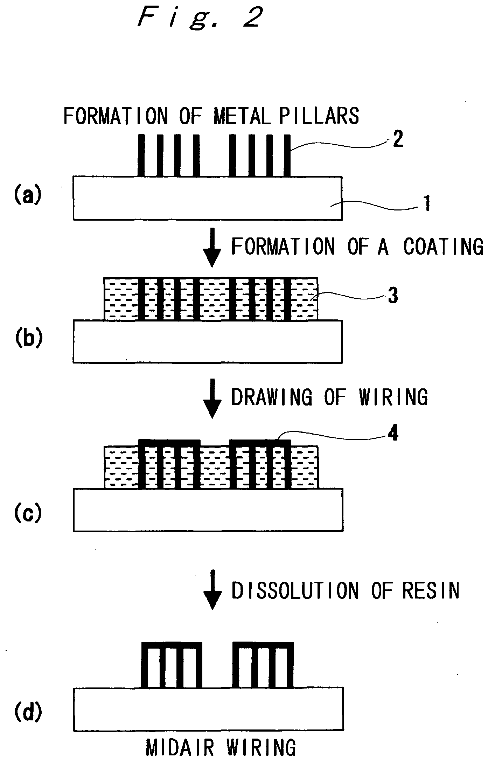

Further, after forming a metal pillar on a substrate and burying it with a resin and then forming a circuit on the substrate, only the resin may be etched and removed, whereby a substrate having midair wiring (Low-K wiring) can be formed (see Figs. 2(a) to 2(d)). In Figs. 2(a) to 2(d), reference numbers 1, 2, 3 and 4 represent the substrate, metal pillar, coating resin, and circuit wiring, respectively. The resin used in this case is preferably a thermosetting resin. Various resins can be used therefor if the resins are soluble.

In the same way as described above, a bump can be formed on a substrate. Specifically, advantages of the fine printing process based on the same inkjet method as described above can be utilized to deposit a metal particulate dispersion in the form of circular cones, thereby forming metal cones having a required size at required positions. This can be sintered at a low temperature to cause the particulates to melt and adhere each other, whereby the bump can be formed.

A diameter of the bottom face of the formed bump is preferably from 0.01 to 100 µm, more preferably from 0.5 to 50 µm, even more preferably from 1 to 50 µm, and a height of the bumps is preferably from 0.1 to 500 µm, more preferably from 1 to 100 µm. The formed bump exhibits a low electrical resistance close to the volume electrical resistivity of the metal itself; therefore, by mounting a fine chip on the bump, a fine chip-mounted substrate can be produced.

In the same way as described above, a metal can be filled into a through hole in a substrate. Specifically, a fine printing method based on the same inkjet method as described above can be used to embed a metal particulate paste in the through hole made in a substrate. This can be sintered for melting and adhering each particulate, whereby the metal can be filled into the through holes.

The inside diameter of the through hole which can be used in the present invention is preferably from 1 to 500 µm, more preferably from 5 to 300 µm, particularly preferably from 20 to 200 µm. The depth thereof is preferably from 5 to 2000 µm, more preferably from 10 to 1000 µm. The through hole can be made by a laser perforating method, a mechanical perforating method, etching or the like.

The metal filled into the through hole has a low electrical resistance close to the volume electrical resistivity of the metal itself. Thereafter, a member can be mounted on the substrate, whereby a chip-mounted multi-layered substrate can be produced.

According to the present invention, the inkjet printing method capable of drawing fine images is used to jet, deposit, and stack a metal particulate dispersion onto a substrate, whereby the substrate can be rendered substrates on which a fine metal pillar is formed.

According to a method of preparing substrates of the present invention, it is possible easily to produce substrates having a structure having a high aspect ratio (the ratio of the height of the structure to the shortest diameter of the bottom face of the structure (the height / the shortest diameter of the bottom face)) which cannot be substantially realized by any conventional method.

A fine metal pillar or a bump in the substrates produced by the method of the present invention have a high metal content by percentage, and have a finely firmed texture so as to exhibit an electrical resistance value close to the volume-electrical resistivity of the metal itself. The chip-mounted substrates, the multi-layered substrates, or the perforated substrates using such a metal pillar or a bump shows an excellent effect that the electrical resistance value thereof is low.

The present invention will be described in more detail based on examples given below, but the invention is not meant to be limited by these.

### Examples

### (Examples 1 to 3, and Comparative Example 1)

In each of Examples 1 to 3, there was prepared a paste-form dispersion exhibiting a liquid viscosity suitable for inkjet printing method and containing silver nano particulates as an electroconductive medium.

As a raw material for the silver nano particulates, the following was used: a commercially available ultra-fine silver particle dispersion (trade name: Independently Dispersed Ultra-Fine Particles Ag1T, manufactured by Vacuum Metallurgical Co., Ltd.), specifically a dispersion of silver particulates 3 nm in average particle size comprising 35 parts by mass of particulates, 7 parts by mass of dodecylamine (molecular weight: 185.36, melting point: 28.3°C, boiling point: 248°C, and a density (d440): 0.7841) as an alkylamine, and 58 parts by mass of toluene as an organic solvent. The liquid viscosity of the silver particulate dispersion was 1 mPa·s (at 20°C).

In a 1-L eggplant type flask, 5.8 g of dodecylamine was firstly added to and mixed with 500 g of the silver particulate dispersion (containing 35% by mass of silver). The mixture was heated and stirred at 80°C for 1 hour. After the end of the stirring, the dispersing solvent toluene contained in the silver particulate dispersion was removed by reduced pressure concentration.

To the mixture, from which the solvent was removed, was added tetradecane (trade name: N14, manufactured by Nikko Petrochemicals Co., Ltd., viscosity: 2.0 to 2.3 mPa·s (20°C), melting point: 5.86°C, boiling point: 253.57°C, density (d420): 0.7924) in each amount shown in Table 1 per 175 parts by mass of the contained silver particulates. The mixture was stirred at room temperature (25°C), so as to prepare a homogenous dispersion. After the end of the stirring, the dispersion was filtrated with a 0.2-µm membrane filter. Each of the resultant dispersion of Examples 1 to 3 and Comparative Example 1 was a homogeneous and highly dark blue silver nano particulate dispersion (silver nano particulate ink) in the form of a highly fluid paste.

Table 1 shows analyzed quantities of components contained in each of the resultant silver nano particulate dispersions (silver nano particulate inks) and the liquid viscosity thereof (measured at 20°C with a B-type rotary viscometer).

For reference, a single substance of silver in a bulk form exhibits a density of 10.49 g·cm⁻³ (at 20°C) and an electrical resistivity of 1.59 µΩ·cm (at 20°C). The average particle size diameter of the silver particulates referred to herein was 3 nm.

**Table 1**

| Composition and properties of produced silver nano particulate dispersions (silver nano particulate inks) | | | | | |
|---|---|---|---|---|---|
| | | Example 1 | Example 2 | Example 3 | Comparative Example 1 |
| Silver particulates (parts by mass) | | 175.0 | 175.0 | 175.0 | 175.0 |
| Total amount of dodecylamine (parts by mass) | | 40.8 | 40.8 | 40.8 | 40.8 |
| Tetradecane (parts by mass) | | 75.9 | 134.2 | 173.1 | 284.2 |
| Silver particulate content (% by mass) | | 60.0 | 50.0 | 45.0 | 35.0 |
| Silver particulate content (% by volume) | | 10.2 | 7.0 | 5.8 | 3.9 |
| Tetradecane content (% by volume) | | 58.5 | 71.4 | 76.3 | 84.1 |
| Amine amount per 100 g of silver | (g) | 23.3 | 23.3 | 23.3 | 23.3 |
| | (moles) | 0.126 | 0.126 | 0.126 | 0.126 |
| Solvent amount per 100 g of silver | (g) | 43.3 | 76.7 | 98.9 | 185.7 |
| | (mL by volume) | 54.6 | 96.8 | 124.8 | 234.3 |
| Liquid viscosity (mPa·s) | | 8 | 5 | 3 | 1 |

**Table 2**

| Application properties of silver nano particulate dispersions (silver nano particulate inks) and evaluation results of resultant sintered bodies | | | | |
|---|---|---|---|---|
| | Example 1 | Example 2 | Example 3 | Comparative Example 1 |
| Dot diameter of a droplet (µm) | 0.6 | 0.7 | 0.9 | 1.5 |
| Interval between image drawing dots (µm) | 30 | 30 | 30 | 30 |
| Diameter of circular bottom faces of applied layers (µm) | 5 | 5 | 5 | >5 |
| Average height of the applied layers (µm) | 28 | 25 | 23 | - |
| Bottom faces diameter of sintered body layers (µm) | 5 | 5 | 5 | - |
| Average height of the sintered body layers (µm) | 25 | 21 | 19 | - |
| Volume electrical resistivity (µΩ·cm) | 2.2 | 2.4 | 2.5 | - |

The resultant silver nano particulate dispersions were each used to draw an image of a pattern having a diameter of 5 µm on a glass with a ultra-fine fluid jet device (ultra-fine inkjet device). At this time, the aperture of jetting-openings made in the ultra-fine inkjet device was selected into 0.6 µm, and the liquid droplet amounts to be jetted out were made into the same value. The diameter of a dot drawn with one liquid droplet from each of the silver nano particulate dispersions is a value shown in Table 2.

Under this drawing condition, the inks were each applied by an inkjet method, so as to form a dot spot pattern wherein intervals between spots were the same, and then the application was repeated in such a manner the same dot spot patterns as described above would be overlapped with each other. In this way, a circular columnar silver nano particle applied layer having a total laminate height shown in Table 2 was produced (see Fig. 1(a)).

When the silver nano particulate dispersions of Examples 1 to 3 were each used, evaporation of the dispersing solvent contained in the applied thin layer advanced during times between the respective application operations. As a result, the applied thin layer was in a viscous state. On the other hand, when the silver nano particulate dispersion of Comparative Example 1 was used, evaporation of the dispersing solvent contained in the applied thin layer advanced as well during times between the respective application operations but the applied thin layer was in a fluid state.

After drawn, the silver nano particulate applied layer on the glass as subjected to heat treatment at 240°C for 1 hour, so as to be fired. In this way, a sintered body layer of the silver nano particulate was formed. The diameter of the circular bottom face of the resultant sintered body layer and the height (thickness) of the sintered body layer were measured with a super depth color 3D shape measuring microscope (trade name: VK-9500, manufactured by Keyence Co.).

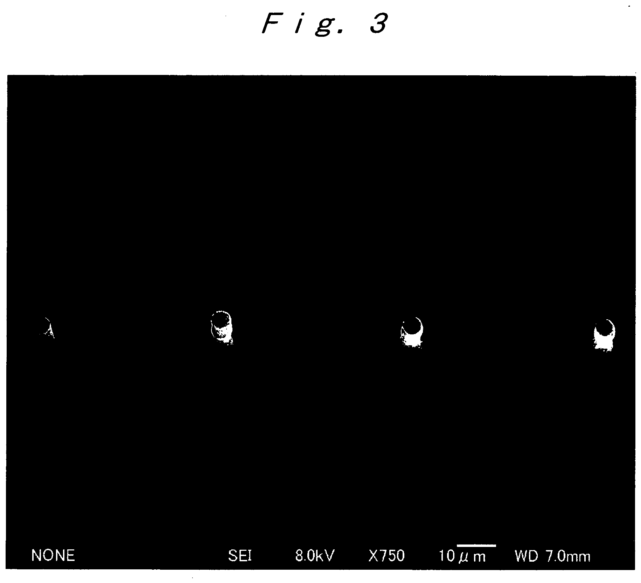

Table 2 shows the following evaluation results: the diameter of a dot drawn with one out of the liquid droplets; the diameter of the circular bottom face of the resultant sintered body layer; and the height (thickness) of the sintered body layer. Furthermore, Fig. 3 shows a printed-out image obtained by observing an external shape of a sintered metal column formed by use of the silver nano particle dispersion of Example 1 in accordance with the above-mentioned production process by means of a field emission type scanning electron microscope (trade name: JSM-6340F, manufactured by JEOL Ltd.) with a power of 750 magnifications.

Separately, the resultant silver nano particulate dispersion was used to print a pattern, 10 mm X 50 mm (in width), on a slide glass under the above-mentioned inkjet laminate-application conditions, so as to give an average film thickness of 10 µm at the time of the laminate-application. After the printing, the nano particle ink laminate-applied layer on the slide glass was subjected to heat treatment at 240°C for 1 hour, so that the contained silver nano particulates were fired. In this way, an electric conductor layer pattern, made of the silver nano particulate sintered body layer, was formed. About the rectangular-film-form electric conductor layers formed by use of the silver nano particulate dispersions of Examples 1 to 3 and Comparative Example 1, each of the layers was regarded as a homogenous electric conductor layer having an average film thickness of the layer, and the volume electrical resistivity thereof was measured. The measurement results of the volume electrical resistivities are also shown in Table 2.

### (Examples 4 and 5, and Comparative Example 2)

In each of Example 4 and 5, there was prepared a paste-form dispersion exhibiting a liquid viscosity suitable for fine inkjet printing method and containing silver nano particulates as an electroconductive medium.

In a 1-L eggplant type flask, 87.5 g (50% by mass of solid silver) of 2-ethylhexylamine (manufactured by Tokyo Kasei boiling point: 169°C) and 52.5 g (30% by mass of solid silver) of dipropylene glycol were added to and mixed with 500 g of the silver particulate dispersion Ag1T (containing 35% by mass of silver and manufactured by Vacuum Metallurgical Co., Ltd.,). The mixture was heated and stirred at 80°C for 1 hour. After the end of the stirring, the dispersing solvent toluene contained in the Ag1T was removed by reduced pressure concentration.

The mixture, from which the solvent was removed, was transferred into a 2-L beaker, and then 1,000 g of a polar solvent, acetone, was added thereto. The mixture was stirred at room temperature for 3 minutes and then allowed to stand still. In this treatment, the silver nano particulates precipitated on the bottom of a beaker while the polar solvent acetone was added and the resultant was stirred and allowed to stand still. Unnecessary organic components contained in the mixture were dissolved in the supernatant to yield a brown acetone solution. This supernatant was removed and then 800 g of acetone was again added to the precipitation. The resultant solution was stirred and allowed to stand still to precipitate silver nano particulates. Thereafter, the acetone solution layer of the supernatant was removed. While the color state of the supernatant acetone layer was observed, 500g of acetone was further added to the precipitation to repeat the same operation. Next, 300 g of acetone was added to the precipitation yielded in the above-mentioned step, and then the solution was stirred and allowed to stand still. At this time, the supernatant acetone layer was watched with the naked eye. No color was found out.

This supernatant acetone layer was removed, and subsequently the acetone solvent remaining in the silver nano particulates precipitating on the bottom of the beaker was vaporized to dry the particulates. As a result, blue fine powder was yielded.

To the resultant blue fine powder was added tetradecane (trade name: N14, manufactured by Nikko Petrochemicals Co., Ltd., melting point: 5.86°C, boiling point: 253.57°C) in each amount shown in Table 3 per 175 parts by mass of the contained silver particulates. Furthermore, to the mixture were added 23.4 g of bis-2-ethylhexylamine (manufactured by Tokyo Kasei (boiling point: 263°C) and 300 g of hexane, and then the mixture was heated and stirred at 70°C for 30 minutes. By this heating and stirring, the silver nano particulates in the blue fine powder form were again dispersed to yield a homogenous dispersion. After the end of the stirring, the dispersion was filtrated with a 0.2-µm membrane filter. Thereafter, hexane in the filtrate was removed by reduced pressure concentration. Each of the resultant dispersion of Examples 4 and 5 and Comparative Example 2 was a homogeneous and highly dark blue silver nano particulate dispersion (silver nano particulate ink) in the form of a highly fluid paste.

Table 3 shows analyzed quantities of components contained in each of the resultant silver nano particulate dispersions (silver nano particulate inks) and the liquid viscosity thereof (measured at 20°C with a B-type rotary viscometer). For reference, a single substance of silver in a bulk form exhibits a density of 10.50 g·cm⁻³ (at 20°C) and an electrical resistivity of 1.59 µΩ·cm (at 20°C). The average particle size diameter of the silver particulates referred to herein was 3 nm.

**Table 3**

| Composition and properties of produced silver nano particulate dispersions (silver nano particulate inks) | | | | |
|---|---|---|---|---|
| | | Example 4 | Example 5 | Comparative Example 2 |
| Silver particulates (parts by mass) | | 175.0 | 175.0 | 175.0 |
| Bis-2-ethylhexylamine (parts by mass) | | 23.4 | 23.4 | 23.4 |
| 2-ethylhexylamine (parts by mass) | | 35.8 | 35.8 | 35.8 |
| Tetradecane (parts by mass) | | 93.6 | 140.4 | 234.0 |
| Silver particulate content (% by mass) | | 53.4 | 46.7 | 35.8 |
| Silver particulate content (% by volume) | | 7.8 | 6.1 | 4.2 |
| Tetradecane content (% by volume) | | 57.2 | 66.7 | 77.0 |
| Amine amount | (g) | 33.8 | 33.8 | 33.8 |
| per 100 g of silver | (moles) | 0.213 | 0.213 | 0.213 |
| Solvent amount | | 53.5 | 80.2 | 133.7 |
| per 100 g of silver | (mL by volume) | 69.8 | 104.6 | 174.3 |
| Liquid viscosity (mPa·s) | | 10 | 5 | 2 |

**Table 4**

| Application properties of silver nano particulate dispersions (silver nano particulate inks) and evaluation results of resultant sintered bodies | | | |
|---|---|---|---|
| | Example 4 | Example 5 | Comparative Example 2 |
| Dot diameter of a droplet (µm) | 0.6 | 0.7 | 1.2 |
| Interval between image drawing dots (µm) | 30 | 30 | 30 |
| Diameter of circular bottom faces of applied layers (µm) | 2.5 | 2.5 | > 2.5 |
| Average height of the applied layers (µm) | 20 | 20 | - |
| Bottom faces diameter of sintered body layers (µm) | 2.5 | 2.5 | - |
| Average height of the sintered body layers (µm) | 15 | 13 | - |
| Volume electrical resistivity (µΩ·cm) | 2.6 | 2.7 | - |

The resultant silver nano particulate dispersions were each used to draw an image of a pattern having a diameter of 2.5 µm on a glass with a ultra-fine fluid jet device (ultra-fine inkjet device). At this time, the aperture of jetting-openings made in the ultra-fine inkjet device was selected into 0.6 µm, and the liquid droplet amounts to be jetted out were made into the same value. The diameter of a dot drawn with one liquid droplet from each of the silver nano particulate dispersions is a value shown in Table 4. Under this drawing condition, the inks were each applied by an inkjet method, so as to form a dot spot pattern wherein intervals between spots were the same, and then the application was repeated in such a manner the same dot spot patterns as described above would be overlapped with each other. In this way, a circular columnar silver nano particle applied layer having a total laminate height shown in Table 4 was produced.

When the silver nano particulate dispersions of Examples 4 and 5 were each used, evaporation of the dispersing solvent contained in the applied thin layer advanced during times between the respective application operations. As a result, the applied thin layer was in a viscous state. On the other hand, when the silver nano particulate dispersion of Comparative Example 2 was used, evaporation of the dispersing solvent contained in the applied thin layer advanced as well during times between the respective application operations but the applied thin layer was in a fluid state.

After drawn, the silver nano particulate applied layer on the glass as subjected to heat treatment at 240°C for 1 hour, so as to be fired. In this way, a sintered body layer of the silver nano particulate was formed.

The diameter of the circular bottom face of the resultant sintered body layer and the height (thickness) of the sintered body layer were respectively measured by microscopic observation. Table 4 shows the following evaluation results: the diameter of a dot drawn with one out of the liquid droplets; the diameter of the circular bottom face of the resultant sintered body layer; and the height (thickness) of the sintered body layer.

Separately, the resultant silver nano particulate dispersion was used to print a pattern, 10 mm X 50 mm (in width), on a slide glass under the above-mentioned inkjet laminate-application conditions, so as to give an average film thickness of 10 µm at the time of the laminate-application. After the printing, the nano particle ink laminate-applied layer on the slide glass was subjected to heat treatment at 240°C for 1 hour, so that the contained silver nano particulates were fired. In this way, an electric conductor layer pattern, made of the silver nano particulate sintered body layer, was formed. About the rectangular-film-form electric conductor layers formed by use of the silver nano particulate dispersions of Examples 4 and 5, each of the layers was regarded as a homogenous electric conductor layer having an average film thickness of the layer, and the volume electrical resistivity thereof was measured. The measurement results of the volume electrical resistivities are also shown in Table 4.

### (Examples 6 and 7, and Comparative Example 3)

In each of Example 6 and 7, there was prepared a paste-form dispersion exhibiting a liquid viscosity suitable for fine inkjet printing method and containing gold nano particulates as an electroconductive medium.

In a 200-mL eggplant type flask, 9.0 g (50% by mass of solid gold) of 2-ethylhexylamine (manufactured by Tokyo Kasei boiling point: 169°C) and 3.6 g (20% by mass of solid gold) of water were added to and mixed with 60 g of the gold particulate dispersion Au1T (containing 30% by mass of gold and manufactured by Vacuum Metallurgical Co., Ltd.,). The mixture was heated and stirred at 80°C for 30 minutes. After the end of the stirring, the dispersing solvent toluene contained in the Au1T was removed by reduced pressure concentration.

The mixture, from which the solvent was removed, was transferred into a 500-mL beaker, and then 300 g of a polar solvent, acetonitrile, was added thereto. The mixture was stirred at room temperature for 3 minutes and then allowed to stand still. In this treatment, the gold nano particulates precipitated on the bottom of a beaker while the polar solvent acetone was added and the resultant was stirred and allowed to stand still. Unnecessary organic components contained in the mixture were dissolved in the supernatant to yield a brown acetonitrile solution. This supernatant was removed and then 300 g of acetonitrile was again added to the precipitation. The resultant solution was stirred and allowed to stand still to precipitate gold nano particulates. Thereafter, the acetonitrile solution layer of the supernatant was removed. While the color state of the supernatant acetonitrile layer was observed, 300g of acetonitrile was further added, and then the solution was stirred and allowed to stand still. At this time, the supernatant acetonitrile layer was watched with the naked eye. No color was found out.

This supernatant acetonitrile layer was removed, and subsequently the acetonitrile solvent remaining in the gold nano particles precipitating on the bottom of the beaker was vaporized to dry the particles. As a result, blackish brown fine powder was yielded.

To the resultant blackish brown fine powder was added an AF7 solvent (manufactured by Nisseki Mitsubishi Kabushiki Kaisha, melting point: 259-282°C, fluid point: -30°C) in each amount shown in Table 5 per 18 parts by mass of the contained gold particulates. Furthermore, to the mixture were added 2.089 g of 2-ethylhexylamine (manufactured by, boiling point: 169°C), 2.732 g of bis 2-ethylhexylamine (manufactured by Tokyo Kasei, boiling point: 263°C) and 100 g of toluene, and then the mixture was heated and stirred at 65°C for 30 minutes. By this heating and stirring, the gold nano particulates in the blackish brown fine powder form were again dispersed to yield a homogenous dispersion. After the end of the stirring, the dispersion was filtrated with a 0.2-µm membrane filter. Thereafter, toluene in the filtrate was removed by reduced pressure concentration. The resultant dispersions of Examples 6 and 7 and Comparative Example 3 were each a homogenous, dark red, gold nano particulate dispersion (gold nano ink) in a highly fluid paste form.

Table 5 shows analyzed quantities of components contained in each of the resultant gold nano particulate dispersions (gold nano particulate inks) and the liquid viscosity thereof (measured at 20°C with a B-type rotary viscometer). For reference, a single substance of gold in a bulk form exhibits a density of 19.32 g·cm⁻³ (at 20°C) and an electrical resistivity of 2.2 µΩ·cm (at 20°C). The average particle size diameter of the gold particulates referred to herein was 5 nm.

**Table 5**

| Composition and properties of produced gold nano particulate dispersions (gold nano particulate inks) | | | | |
|---|---|---|---|---|
| | | Example 6 | Example 7 | Comparative Example 3 |
| Gold particulates (parts by mass) | | 18.0 | 18.0 | 18.0 |
| Bis-2-ethylhexylamine (parts by mass) | | 2.040 | 2.040 | 2.040 |
| 2-ethylhexylamine (parts by mass) | | 5.289 | 5.289 | 5.289 |
| AF7 solvent (parts by mass) | | 8.40 | 12.60 | 25.20 |
| Gold particulate content (% by mass) | | 53.4 | 47.5 | 35.6 |
| Gold particulate content (% by volume) | | 4.6 | 3.7 | 2.3 |
| AF solvent content (% by volume) | | 49.8 | 59.8 | 74.8 |
| Amine amount per 100 g of gold | (g) | 40.7 | 40.7 | 40.7 |
| | (moles) | 0.274 | 0.274 | 0.274 |
| Solvent amount per 100 g of gold | (g) | 46.7 | 70.0 | 140.0 |
| | (mL by volume) | 56.0 | 83.9 | 167.9 |
| Liquid viscosity (mPa·s) | | 12 | 7 | 3 |

**Table 6**

| Application properties of gold nano particulate dispersions (gold nano particulate inks) and evaluation results of resultant sintered bodies | | | |
|---|---|---|---|
| | Example 6 | Example 7 | Comparative Example 3 |
| Dot diameter of a droplet (µm) | 0.7 | 0.8 | 1.9 |
| Interval between image drawing dots (µm) | 30 | 30 | 30 |
| Diameter of circular bottom faces of applied layers (µm) | 8.0 | 8.0 | > 8.0 |
| Average height of the applied layers (µm) | 10 | 10 | - |
| Bottom faces diameter of sintered body layers (µm) | 8.0 | 8.0 | - |
| Average height of the sintered body layers (µm) | 7.0 | 6.7 | - |
| Volume electrical resistivity (µΩ·cm) | 3.1 | 3.4 | - |

The gold nano particulate dispersions prepared in Example 6 was each used to draw an image of a disklike pattern having a bottom face 8 µm in diameter on a glass with a superfine fluid spraying device (superfine inkjet device). At this time, the aperture of jetting-openings made in the superfine inkjet device was selected into 0.6 µm, and the liquid droplet amounts to be jetted out were made into the same value. The diameter of a dot drawn with one liquid droplet from each of the gold nano particulate dispersions is a value shown in Table 6. Under this drawing condition, the inks were each applied by an inkjet method, so as to form a dot spot pattern wherein intervals between spots were the same, and then the application was repeated in such a manner the same dot spot patterns as described above by an inkjet method would be overlapped with each other. In this way, a circular conic gold nano particulate applied layer having a total laminate height shown in Table 6 was produced.

When the gold nano particulate dispersions of Examples 6 and 7 were each used, evaporation of the dispersing solvent contained in the applied thin layer advanced during times between the respective application operations. As a result, the applied thin layer was in a viscous state. On the other hand, when the gold nano particulate dispersion of Comparative Example 3 was used, evaporation of the dispersing solvent contained in the applied thin layer advanced as well during times between the respective application operations but the applied thin layer was in a fluid state.

After drawn, the gold nano particulate applied layer on the glass as subjected to heat treatment at 240°C for 1 hour, so as to be fired. In this way, a sintered body layer of the gold nano particulate was formed.

The diameter of the circular bottom face of the resultant sintered body layer and the height (thickness) of the sintered body layer were measured by observation with a microscope. Table 6 shows the following evaluation results: the diameter of a dot drawn with one out of the liquid droplets; the diameter of the circular bottom face of the resultant sintered body layer; and the height (thickness) of the sintered body layer.

Separately, the resultant gold nano particulate dispersion was used to print a pattern, 10 mm X 50 mm (in width), on a slide glass under the above-mentioned inkjet laminate-application conditions, so as to give an average film thickness of 3 µm at the time of the laminate-application. After the printing, the nano particle ink laminate-applied layer on the slide glass was subjected to heat treatment at 240°C for 1 hour, so that the contained gold nano particulates were fired. In this way, an electric conductor layer pattern, made of the gold nano particulate sintered body layer, was formed. About the rectangular-film-form electric conductor layers formed by use of the gold nano particulate dispersions of Examples 6 and 7, each of the layers was regarded as a homogenous electric conductor layer having an average film thickness of the layer, and the volume electrical resistivity thereof was measured. The measurement results of the volume electrical resistivities are also shown in Table 6.

### (Example 8)

The silver nano particulate dispersion prepared in Example 1 was used to draw a conical pattern having a bottom face having a diameter of 20 µm on a glass with a ultra-fine fluid jet device (ultra-fine inkjet device). Conditions for the drawing were made the same as in Example 1, and the dispersion was repeatedly applied onto the same pattern by an inkjet method many times so as to form a conical silver nano particulate applied layer wherein the total laminate thickness (height) of its center was 20 µm. After the drawing, the conical silver nano particulate layer on the glass was subjected to heat treatment at 240°C for 1 hour, so as to be fired. In this way, a sintered body layer of the silver nano particulates was formed. In the resultant sintered body layer, the conical external shape having a bottom face 20 µm in diameter was kept so that this layer was formed into a conical sintered metal pad (bump) having a circular bottom face having a diameter of 20 µm and having, as its center, a thickness of 10 µm.

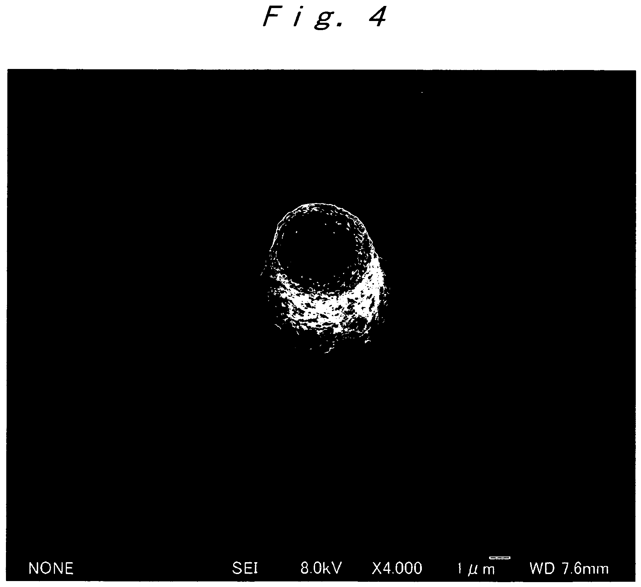

Fig. 4 shows a printed-out image obtained by observing the external shape of the sintered metal pad by means of the field emission type scanning electron microscope (trade name: JSM-6340F, manufactured by JEOL Ltd.) with a power of 4000 magnifications.

It can be considered that the thus-formed conical metal structure can be used as a stud bump as described in "the Journal of Japan Institute of Electronics Packing", 2000, vol. 6, No. 2, pp. 122-125.

### (Example 9)

Through holes 200 µm in diameter were made in a substrate material for multi-layered wiring so as to extend from the surface of the upper layer of the substrate to the rear face of the upper layer (i.e., the upper face of the lower layer thereof). The thickness (hole depth) of the upper layer of the substrate for multi-layered wiring, in which the through holes were made, was 1.6 mm, and the ratio of the hole diameter of the through holes to the depth thereof was 1/8 (8 as the aspect ratio). In this way, the aspect ratio was selected into a high value. At the rear face side thereof, a wiring layer on the upper surface of the lower layer was arranged, and electric conductor filling regions to be made in the through holes was made into a form for attaining via hole connection.

The silver nano particulate dispersion prepared in Example 1 was used to draw silver nano particulate filling application layers into the through holes 200 µm in diameter with a ultra-fine fluid jet device (ultra-fine inkjet device). Drawing conditions for the filling application were made the same as in Example 1, and the dispersion was repeatedly applied into the through holes by an inkjet method many times so as to form silver nano particle layers filled completely into the through holes 1.6 mm in depth. After the dispersion was applied and filled, the silver nano particulate layers in the through holes were subjected to heat treatment at 240°C for 1 hour, so as to be fired. In this way, sintered body filled layers of the silver nano particulates were formed.

The resultant sintered body filled layers of the silver nano particulates each had a shape adhering to the side wall face of the through holes.

### (Example 10)

There were prepared a product wherein a block copolymer polyimide vanish (such as a solution wherein polyimide vanish Q-PILON series, Q-VR-319A (trade name) manufactured by Kabushiki Kaisha P I Technical Institute was diluted with a solvent) was dropped little by little onto the substrate obtained in Example 1, wherein the metal pillars were grown, with sufficiently careful attention; and a product wherein the above-mentioned substrate was dip-coated with the solution. Next, these were subjected to heat treatments at 120°C for 20 minutes, 180°C for 20 minutes and 250°C for 30 minutes step by step, thereby forming an insulator coating film. In this way, an insulated substrate wherein the through holes (via holes) were filled with·the metal was produced (see Fig. 1(b)).

As is evident from the present example, a three-dimensional wiring image can be drawn by forming a wiring pattern beforehand on a silicon substrate and then forming metal pillars on specific sites thereof.

### (Example 11)

In the same way as in Example 1, a ultra-fine inkjet device and a silver nano paste were used to draw a wiring pattern on the substrate with via holes of Example 10 and form metal pillars, and then the resultant was subjected to heat treatment in order to cure silver therein. The resultant was further subjected to the same treatment as in Example 10. This made it possible to form a multi-layered substrate without performing any perforating operation (see Figs. 1(d) to (f)).

### (Example 12)

The substrate obtained in Example 10 was treated with a 55% ferric nitrate solution to dissolve the silver metal pillars, thereby producing a substrate having through holes (perforated substrate) having a diameter of 1 µm, a depth of 50 µm and a high aspect ratio in the insulator film (see Fig. 1(c)).

Of minute working techniques, working for making holes having a diameter of 1 µm or less and a high aspect ratio is usually very difficult, and requires an expensive device and a complicated process. On the other hand, the present invention has made it possible to realize this technique, without using any expensive device or any complicated process, by use of a simple manner of inkjet. For reference, a more complicated flow channel can also be formed by performing the above-mentioned etching process using the multi-layered substrate of Example 11.

A wiring pattern held in midair can also be obtained by drawing a wiring pattern on the substrate of Example 10, wherein the metal pillars were buried in the resin, with a silver nano paste or the like, subjecting the resultant to heat treatment, and treating the resultant substrate with a solvent or the like, thereby dissolving the resin (see Figs. 2(a) to (d)).

### Industrial Applicability

According to the method of the present invention for preparing substrates, it is possible to prepare substrates having a structure which exhibits such fineness and height in aspect ratio that cannot be realized by conventional methods, at a high producing speed, by use of fewer resources and less energy. Thus, industrial applicability thereof is high.

The chip-mounted substrates, the multi-layered substrates, the perforated substrates and so on which are produced by the preparation method of the present invention have a fine structure and a low resistance value. Thus, these can widely be used as mechanical elements such as an actuator, MEMS'es, optical elements, semiconductor probes and others.

Having described our invention as related to the present embodiments, it is our intention that the invention not be limited by any of the details of the description, unless otherwise specified, but rather be construed broadly within its scope as set out in the accompanying claims.

## Claims

1. A method of preparing substrates, comprising the steps of:
depositing metal particulates into a pillar form at a prescribed position of a substrate by the use of a fine inkjet method; and
then sintering the resultant to form a metal pillar,
wherein the metal particulates are contained in a dispersion or paste with a concentration of 40% by mass or more, and
wherein the fine inkjet method is a structure-forming method, which comprises flying and landing a fine liquid droplet of the dispersion or paste having a diameter of 1 µm or less, drying and solidifying the liquid droplet, and stacking the solidified droplets by virtue of the focusing of an electric field, wherein continuously discharging the fine fluid droplets from a nozzle and stacking the fine fluid droplets, wherein by virtue of an applied electric field, stress directed to the tip of the nozzle constantly acts at a top part of a structure formed by the solidification of precedently adhering liquid droplets, thereby growing the structure while pulling the structure towards the nozzle.

2. The method of preparing substrates according to claim 1, wherein the metal pillar is a bump.

3. The method of preparing substrates according to claim 1, wherein a metal material is filled into a through hole made on the substrate so as to form a metal pillar.

4. The method of preparing substrates according to claim 1, wherein a height of the metal pillar is in a range of from 10 to 100 µm.

5. The method of preparing substrates according to claim 1 or 4, wherein a bottom face diameter of the metal pillar is in a range of from 0.5 to 10 µm.

6. The method of preparing substrates according to claim 2, wherein a bottom face diameter of the bump is in a range of from 0.5 to 50 µm.

7. The method of preparing substrates according to claim 3, wherein an inside diameter of the through hole is in a range of from 1 to 500 µm.

8. The method of preparing substrates according to any one of claims 1 to 7, wherein the metal particulates are made of at least one metal selected from the group consisting of gold, silver, copper, platinum, palladium, tungsten, nickel, tantalum, bismuth, lead, indium, tin, zinc, titanium, and aluminum.

9. The method of preparing substrates according to any one of claims 1 to 8, wherein a particulate size of the metal particulates is in a range of from 1 to 100 nm.

10. The method of preparing substrates according to any one of claims 1 to 7, wherein the metal particulates are gold particulates having an average particulate size in a range of from 1 to 20 nm, and a dispersion containing the gold particulates in an amount of 40 % by mass or more is used as a fluid to be discharged.

11. The method of preparing substrates according to any one of claims 1 to 7, wherein the metal particulates are silver particulates having an average particulate size in a range of from 1 to 20 nm, and a dispersion containing the silver particulates in an amount of 40 % by mass or more is used as a fluid to be discharged.

12. The method of preparing substrates according to any one of claims 1 to 11, wherein a temperature for sintering the metal particulates is in a range of from 150 to 300°C.

13. A method of producing chip-mounted substrates, comprising the steps of: forming a circuit on a substrate; forming a metal pillar at a prescribed position of the substrate in the method according to any one of claims 1, 4, 5 and 7 to 12; mounting a member on the substrate; and sealing the resultant with a resin.

14. A method of producing multi-layered substrates, comprising the steps of: forming a circuit on the chip-mounted substrates produced according to the method of claim 13; and repeating the steps in the method of claim 13.

15. A method of producing chip-mounted substrates, comprising the steps of: forming a circuit on a substrate; forming a bump on a prescribed position of the substrate in the method according to any one of claims 2, 6, and 7 to 12; and mounting a member on the bump.

16. A method of producing multi-layered substrates, comprising the steps of: forming a circuit on a substrate; making a through hole in a prescribed position of the substrate; and embedding a metal into the through hole by the use of the method according to any one of claims 3, 7 and 8 to 12.

## Patentansprüche

1. Verfahren zur Herstellung von Substraten, welches die Schritte umfasst:
das Abscheiden von partikulären Teilchen aus Metall in eine Säulenform an einer vorgeschriebenen Position eines Substrats unter Verwendung eines Verfahrens, das einen feinen Tintenstrahl benutzt; und
dann das Sintern des Erhaltenen, um eine Säule aus Metall zu bilden, wobei die partikulären Teilchen aus Metall in einer Dispersion oder einer Paste mit einer Konzentration von 40 Massen-% oder mehr enthalten sind, und
wobei das Verfahren, das einen feinen Tintenstrahl benutzt, ein Verfahren zur Bildung einer Struktur ist, das umfasst: das Fliegen und Landen eines feinen Flüssigkeitströpfchens der Dispersion oder Paste, welches einen Durchmesser von 1 µm oder weniger aufweist; das Trocknen und Verfestigen des Flüssigkeitströpfchens, und das Stapeln der verfestigten Tröpfchen mit Hilfe der Fokussierung eines elektrischen Feldes, wobei die feinen Flüssigkeitströpfchen kontinuierlich von einer Düse abgegeben werden und die feinen Flüssigkeitströpfchen kontinuierlich gestapelt werden, wobei, mit Hilfe eines angelegten elektrischen Felds, eine Belastung, die auf die Spitze der Düse gerichtet ist, ständig auf einen oberen Teil einer Struktur, die durch die Erstarrung von vorhergehend anhaftenden flüssigen Tröpfchen gebildet wird, wirkt, wodurch die Struktur wächst, während die Struktur in Richtung der Düse gezogen wird.

2. Das Verfahren zur Herstellung von Substraten nach Anspruch 1, wobei die Metallsäule eine Erhebung ist.

3. Das Verfahren zur Herstellung von Substraten nach Anspruch 1, wobei ein Material aus Metall in ein auf dem Substrat ausgebildetes Durchgangsloch gefüllt wird, um auf diese Weise eine Säule aus Metall zu bilden.

4. Das Verfahren zur Herstellung von Substraten nach Anspruch 1, wobei die Höhe der Säule aus Metall in einem Bereich von 10 bis 100 µm liegt.

5. Das Verfahren zur Herstellung von Substraten nach Anspruch 1 oder 4, wobei der Durchmesser an der Unterseite der Säule aus Metall in einem Bereich von 0,5 bis 10 µm liegt.

6. Das Verfahren zur Herstellung von Substraten nach Anspruch 2, wobei der Durchmesser an der Unterseite der Erhebung in einem Bereich von 0,5 bis 50 µm liegt.

7. Das Verfahren zur Herstellung von Substraten nach Anspruch 3, wobei der Innendurchmesser des Durchgangslochs in einem Bereich von 1 bis 500 µm liegt.

8. Das Verfahren zur Herstellung von Substraten nach einem der Ansprüche 1 bis 7, wobei die partikulären Teilchen aus Metall hergestellt sind aus mindestens einem Metall, welches aus der Gruppe, die aus Gold, Silber, Kupfer, Platin, Palladium, Wolfram, Nickel, Tantal, Wismut, Blei, Indium, Zinn, Zink, Titan und Aluminium besteht, ausgewählt ist.

9. Das Verfahren zur Herstellung von Substraten nach einem der Ansprüche 1 bis 8, wobei die Partikelgröße der partikulären Teilchen aus Metall in einem Bereich von 1 bis 100 nm liegt.

10. Das Verfahren zur Herstellung von Substraten nach einem der Ansprüche 1 bis 7, wobei die partikulären Teilchen aus Metall partikuläre Goldteilchen sind, die eine mittlere Partikelgröße in einem Bereich von 1 bis 20 nm aufweisen, und eine Dispersion, welche die partikulären Goldteilchen in einer Menge von 40 Massen-% oder mehr enthält, als eine Flüssigkeit verwendet wird, die abgegeben werden soll.

11. Das Verfahren zur Herstellung von Substraten nach einem der Ansprüche 1 bis 7, wobei die partikulären Teilchen aus Metall partikuläre Silberteilchen sind, die eine mittlere Partikelgröße in einem Bereich von 1 bis 20 nm aufweisen, und eine Dispersion, welche die partikulären Goldteilchen in einer Menge von 40 Massen-% oder mehr enthält, als eine Flüssigkeit verwendet wird, die abgegeben werden soll.

12. Das Verfahren zur Herstellung von Substraten nach einem der Ansprüche 1 bis 11, wobei die Temperatur zum Sintern der partikulären Teilchen aus Metall in einem Bereich von 150 bis 300 °C liegt.

13. Verfahren zur Herstellung von Substraten, die an einem Chip befestigt sind, welches die Schritte umfasst: das Bilden einer Schaltung auf einem Substrat; das Bilden einer Säule aus Metall an einer vorgeschriebenen Position des Substrats gemäß dem Verfahren nach einem der Ansprüche 1, 4, 5 und 7 bis 12; das Befestigen eines Elements auf dem Substrat; und das Versiegeln des Erhaltenen mit einem Harz.

14. Verfahren zur Herstellung von vielschichtigen Substraten, welches die Schritte umfasst: das Bilden einer Schaltung auf den auf einem Chip befestigten Substraten, die gemäß dem Verfahren nach Anspruch 13 hergestellt worden sind; und das Wiederholen der Schritte aus dem Verfahren nach Anspruch 13.

15. Verfahren zur Herstellung von Substraten, die an einem Chip befestigt sind, welches die Schritte umfasst: das Bilden einer Schaltung auf einem Substrat; das Bilden einer Erhebung an einer vorgeschriebenen Position des Substrats gemäß dem Verfahren nach einem der Ansprüche 2, 6 und 7 bis 12; und das Befestigen eines Elements auf der Erhebung.

16. Verfahren zur Herstellung von vielschichtigen Substraten, welches die Schritte umfasst: das Bilden einer Schaltung auf einem Substrat; das Erzeugen eines Durchgangslochs an einer vorgeschriebenen Position des Substrats; und das Einbetten eines Metalls in das Durchgangsloch unter Verwendung des Verfahrens gemäß einem der Ansprüche 3, 7 und 8 bis 12.

## Revendications

1. Procédé de préparation de substrats, comprenant les étapes suivantes :
dépôt de matières particulaires métalliques sous forme de pilier à une position prescrite d'un substrat à l'aide d'un procédé jet d'encre fine ; et
frittage du dépôt obtenu pour former un pilier métallique,
dans lequel les matières particulaires métalliques sont contenues dans une dispersion ou une pâte à une concentration de 40 % en poids ou plus, et
dans lequel le procédé jet d'encre fine est un procédé formant une structure, qui comprend le vol et l'atterrissage d'une fine gouttelette liquide de la dispersion ou de la pâte ayant un diamètre de 1 µm ou moins, le séchage et la solidification de la gouttelette liquide, et l'empilement des gouttelettes solidifiées en vertu de la focalisation d'un champ électrique, de façon que par l'éjection continue des fines gouttelettes liquides d'une buse et l'empilement des fines gouttelettes liquides, en vertu du champ électrique appliquée, la contrainte dirigée sur la pointe de la buse agisse de manière constante sur une partie supérieure d'une structure formée par la solidification des gouttelettes liquides ayant adhéré précédemment, pour faire ainsi croître la structure tout en tirant la structure en direction de la buse.

2. Procédé de préparation de substrats selon la revendication 1, dans lequel le pilier métallique est une bosse.

3. Procédé de préparation de substrats selon la revendication 1, dans lequel un trou débouchant ménagé sur le substrat est rempli avec un matériau métallique de façon à former un pilier métallique.

4. Procédé de préparation de substrats selon la revendication 1, dans lequel une hauteur du pilier métallique est dans une plage de 10 à 100 µm.

5. Procédé de préparation de substrats selon la revendication 1 ou 4, dans lequel un diamètre de face inférieure du pilier métallique est dans une plage de 0,5 à 10 µm.

6. Procédé de préparation de substrats selon la revendication 2, dans lequel un diamètre de face inférieure de la bosse est dans une plage de 0,5 à 50 µm.

7. Procédé de préparation de substrats selon la revendication 3, dans lequel un diamètre interne du trou débouchant est dans une plage de 1 à 500 µm.

8. Procédé de préparation de substrats selon l'une quelconque des revendications 1 à 7, dans lequel les matières particulaires métalliques sont à base d'au moins un métal choisi dans le groupe constitué par l'or, l'argent, le cuivre, le platine, le palladium, le tungstène, le nickel, le tantale, le bismuth, le plomb, l'indium, l'étain, le zinc, le titane, et l'aluminium.

9. Procédé de préparation de substrats selon l'une quelconque des revendications 1 à 8, dans lequel une taille de particules des matières particulaires métalliques est dans une plage de 1 à 100 nm.

10. Procédé de préparation de substrats selon l'une quelconque des revendications 1 à 7, dans lequel les matières particulaires métalliques sont des particules d'or ayant une taille de particule moyenne dans une plage de 1 à 20 nm, et une dispersion contenant les particules d'or en une quantité de 40 % en poids ou plus est utilisée à titre de fluide à éjecter.

11. Procédé de préparation de substrats selon l'une quelconque des revendications 1 à 7, dans lequel les matières particulaires métalliques sont des particules d'argent ayant une taille de particule moyenne dans une plage de 1 à 20 nm, et une dispersion contenant les particules d'argent en une quantité de 40 % en poids ou plus est utilisée à titre de fluide à éjecter.

12. Procédé de préparation de substrats selon l'une quelconque des revendications 1 à 11, dans lequel une température de frittage des matières particulaires métalliques est dans une plage de 150 à 300 °C.

13. Procédé de production de substrats montés sur puces, comprenant les étapes suivantes : formation d'un circuit sur un substrat ; formation d'un pilier métallique à une position prescrite du substrat par le procédé selon l'une quelconque des revendications 1, 4, 5 et 7 à 12 ; montage d'un élément sur le substrat ; et scellement du produit obtenu à l'aide d'une résine.

14. Procédé de production de substrats multicouches, comprenant les étapes suivantes : formation d'un circuit sur les substrats montés sur puces obtenus par le procédé selon la revendication 13 ; et répétition des étapes du procédé selon la revendication 13.

15. Procédé de production de substrats montés sur puces, comprenant les étapes suivantes : formation d'un circuit sur un substrat ; formation d'une bosse à une position prescrite du substrat par le procédé selon l'une quelconque des revendications 2, 6, et 7 à 12 ; et montage d'un élément sur la bosse.

16. Procédé de production de substrats multicouches, comprenant les étapes suivantes : formation d'un circuit sur un substrat ; formation d'un trou débouchant à une position prescrite du substrat ; et remplissage du trou débouchant avec un métal à l'aide du procédé selon l'une quelconque des revendications 3, 7 et 8 à 12.
